Europäisches Patentamt

(19) European Patent Office

Office européen des brevets

(11) Publication number: **0 160 433**

A2

(12) # EUROPEAN PATENT APPLICATION

(21) Application number: 85302516.1

(22) Date of filing: 10.04.85

(51) Int. Cl.⁴: **H 01 L 35/32**
**H 01 L 35/10**

(30) Priority: 23.04.84 US 603009

(43) Date of publication of application:
06.11.85 Bulletin 85/45

(84) Designated Contracting States:
BE CH DE FR GB IT LI NL SE

(71) Applicant: OMNIMAX ENERGY CORPORATION
121 South Broad Street
Philadelphia Pennsylvania 19107(US)

(72) Inventor: Shakun, Wallace
420 Jefferson Circle
Atlanta Georgia 30328(US)

(74) Representative: Oliver, Roy Edward et al,
POLLAK MERCER & TENCH High Holborn House 52-54
High Holborn
London WC1V 6RY(GB)

(54) Thermoelectric generator using variable geometry with support pedestals of materials different from the basic thermoelectric semiconductor elements.

(57) A thermoelectric generator in which the effective figure of merit and/or the effective power coefficient is optimized by providing thermoelements made from semi-conductor materials supported on pedestals made from materials having good electrical and thermal conductivity properties.

EP 0 160 433 A2

- 1 -

## THERMOELECTRIC GENERATOR USING VARIABLE GEOMETRY WITH SUPPORT PEDESTALS OF MATERIALS DIFFERENT FROM THE BASIC THERMOELECTRIC SEMI-CONDUCTOR ELEMENTS

### Background Of The Invention

Thermoelectric generators or thermocouples are formed of two dissimilar materials joined together at one end with the other ends connected to an electrical load. The ends connected together are at a higher temperature than the other ends. The temperature differential produces a flow of current and a common use of the thermocouple is in measurement of temperature.

Thermopiles may be constructed by connecting thermocouples or thermoelectric generators in series to maximize current and voltage output. In connecting thermocouples or thermoelectric generators together to form a thermopile, one group of junctions are placed in the hotter zone and the other group of junctions are placed in the colder zone. By connecting many of such thermocouples or thermoelectric generators in series, the generation of electricity at low efficiency can be achieved. Throughout this specification the term "thermoelectric generator" shall mean thermocouple or thermopile.

Utilizing the reverse effect by introducing the electricity into the thermoelectric generator, rather than having the thermoelectric generator generate electricity, and having the hot junction in ambient air and the cold junction in a contained zone to be cooled, a thermoelectric generator can be used to produce a refrigerating device, again of low efficiency, however.

Recent patents have been directed to improvements in the efficiency of the thermopile by increasing the cross-sectional area of the junction so that it is larger than the cross-sectional area of the hot junction so that it is larger than the cross-sectional area of the legs or the cold junction, as in U.S. Patent No. 4,251,290, Gomez, U.S. Patent No. 4,251,291, Gomez, U.S. Patent No. 2,257,822, Gomez, and U.S. Patent No. 4,444,991, Beale. While these patents are concerned with improvements in efficiency - through the geometry of the junction cross-sectional area and the legs cross-sectional area, they are not directed to optimizing the effective figure of merit of the system or the effective power output.

## Summary Of The Invention

This invention relates to a novel thermoelectric generator in which the effective figure of merit and the effective power coefficient may be optimized. This is accomplished by providing a thermoelectric generator formed from thermoelements made from semi-conductor materials supported on pedestals made from materials having good electrical and thermal conductivity. The optimum size and shape of the thermoelectric generator, depending upon the materials used, can also be determined.

It is therefore an object of this invention to increase the power output per amount of thermoelectric element material as compared with the present state of the art.

It is a still further object of this invention to increase the operational efficiency of a thermoelectric generator.

It is a still further object of this invention to provide sufficient spacing between the heat source and the heat sink temperatures in order to maintain large differences in junction temperatures.

It is a still further object of this invention to increase the power output and current density with a decrease in the amount of the thermoelectric semi-conductor material utilized.

It is a still further object of this invention to maintain a constant efficiency by decreasing the amount of the thermoelectric semi-conductor material by replacing the semi-conductor material with a less expensive support pedestal material.

These, together with other objectives and advantages of the invention, should become apparent in the details of construction and operation, as more fully described herein and claimed, reference being had to the accompanying drawings forming a part hereof wherein like numerals refer to like parts throughout.

Brief Description Of The Drawings

Fig. 1 is a perspective view of the basic thermoelectric generator of this invention.

Fig. 2 shows the thermoelectric generator of Fig. 1 connected in series to form a thermopile or thermoelectric generator.

Fig. 3 is a graph showing the effect of a change in length of a copper support pedestal on the power output and efficiency of a thermoelectric generator for a given weight of a particular thermoelement material, specifically bismuth telluride.

Fig. 4 is a graph showing the effect of an increase in the length of a copper support pedestal with the thermoelements being maintained at a fixed length.

Fig. 5 shows a typical temperature gradient for the thermoelectric generator of this invention.

Detailed Description Of The Invention

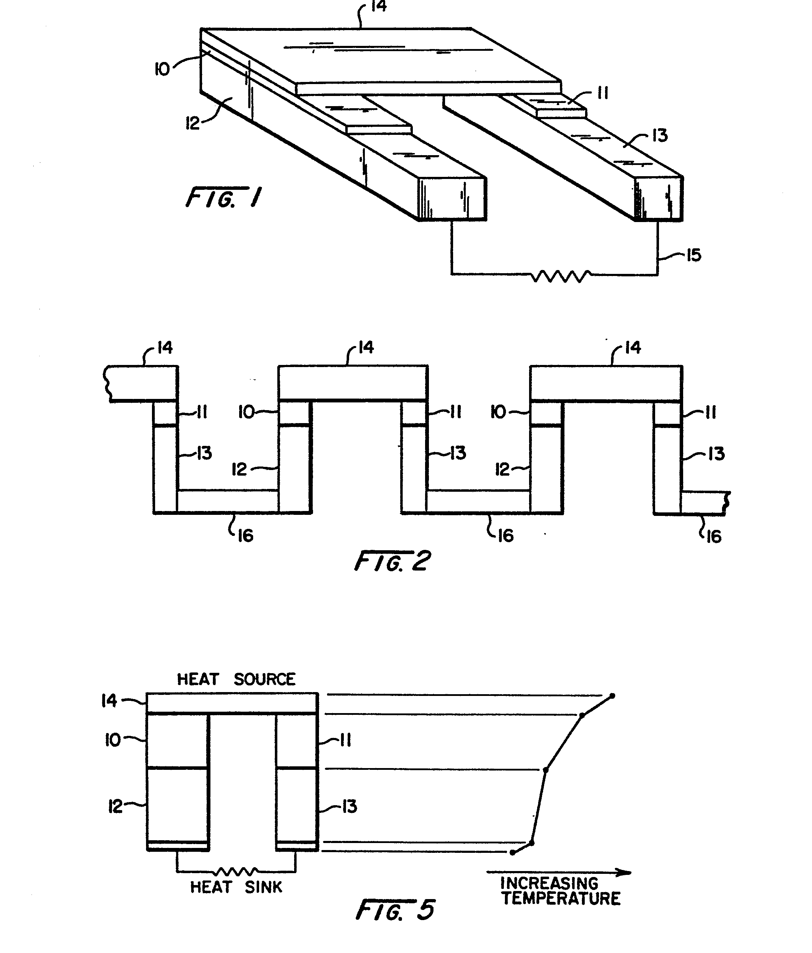

Referring now more particularly to Fig. 1, the thermoelements are shown at 10 and 11, respectively. They are supported on pedestal supports 12 and 13 and thermoelements 10 and 11 are connected together by means of a bridging conductor 14. The other ends of the support pedestals 12 and 13 may be connected to an electrical load 15.

Referring now more particularly to Fig. 2, the basic thermoelectric elements are connected in series with conductors 16-16 connecting pedestal supports 12 and 13.

The efficiency and power output of thermoelectric generator are dependent upon the material properties of the thermoelements. The basic configuration of a thermoelectric generator consists of two thermoelement-type materials forming a junction in contact with the source of heat, while the other ends of the thermoelements are in thermal contact with the heat sink. The heat sink is at a lower temperature than the heat source. Electric power is delivered to the external resistance 15 ($R_E$) proportional to the temperature difference between the heat source and the heat sink and the intrinsic material properties of the thermocouple. The intrinsic material properties are the Seebeck coefficient ($\alpha$), the thermal conductivity (k) and the electrical conductivity ($\sigma$). Combining the intrinsic material properties, the geometry of the thermal elements making up the thermocouple and subscripting the two branches of the thermocouples to denote the positive and negative conductors (as p and n), each conductor having absolute Seebeck coefficients, respectively, the electrical resistance (R) of the thermal elements is:

$$R = \frac{1p}{S_p \sigma_p} + \frac{1n}{S_n \sigma_n}$$

where "1" represents the length of the thermoelement, "S" represents the cross-sectional area of the thermoelement, and "   " the electrical conductivity for each thermoelement.

The thermal conductance "K" of the thermoelement is

$$K = \frac{S_p k_p}{l_p} + \frac{S_n k_n}{l_n}$$

where "k" is the thermal conductivity. Combining the thermal conductance, electrical resistance, and the Seebeck coefficient, the figure of merit of the basic thermoelement is

$$z = \frac{|\alpha_n| + |\alpha_p|}{RK}$$

The selection of the thermoelectric materials is governed by the figure of merit and the temperature limitations of the materials. Materials with a high "Z" value, which can be operated at high temperature differentials (a high temperature capability at the heat source side) produce more power output. The important consideration in designing a thermoelectric generator is to select a material with a high "Z" value; also being operable at a particular operating source temperature and then optimizing the geometric parameters. Satisfactory materials for thermoelectric elements are semi-conductors such as bismuth telluride, lead telluride, or silicon germanium, depending upon the source temperature involved.

The maximum efficiency of a thermoelectric generator can be defined as the electrical energy delivered to an external circuit divided by the energy consumed from the heat source. The maximum efficiency is

$$\left( \frac{T_0 - T_1}{T_0} \right) \times \left( \frac{M-1}{M + \frac{T_0}{T_1}} \right)$$

where

$$\frac{T_0 - T_1}{T_0}$$

is the thermodynamic efficiency of a reversible engine and

$$\frac{M - 1}{M + \dfrac{T_0}{T_1}}$$

is the reduction in the maximum efficiency due to irreversible losses with

$$M = \left(1 + \frac{Z (T_1 + T_0)}{2}\right)^{1/2}$$

and

$T_0$ = sink junction temperature, $^0K$

$T_1$ = source junction temperature, $^0K$

The power output from the thermoelements is found by combining the relationships for the temperature differential and the current. The results are

$$P = \text{Power output/per thermoelement} = \left(\frac{\alpha_0 \Delta T}{R + R_e}\right)^2 x\ R_e$$

and

$$\alpha_0 = |\alpha_n| + |\alpha_p|$$
$$\Delta T = T_0 - T_1$$

This equation indicates the sensitivity of the power output to the Seebeck coefficient, the temperature differential, and the internal resistance. A more general expression for the figure of merit previously set forth is to introduce an effective figure of merit ($Z_{eff}$). The effective figure of merit includes the effects of junction resistance, integrated average material properties, and interelement thermal effects. The resulting expressions for efficiency and power output will then reflect the effective thermal conductance:

$$K_{eff} = K + K_i$$

Where $K_i$ is the thermal conductance of the interelement material and the effective internal resistance is

$$R_{eff} = R + R_j$$

where $R_j$ is the combined junction resistances.

In order to increase the effective figure of merit ($Z_{eff}$) as defined by

$$Z_{eff} = \frac{\left| \alpha_n \right| + \left| \alpha_p \right|}{R_{eff} \times K_{eff}}$$

then it is necessary to decrease $R_{eff}$ and/or $K_{eff}$.

In the prior art, the method presently utilized for decreasing $R_{eff}$ and $K_{eff}$ for a given material is to adjust the thermoelectric element geometry which makes the product $(K_{eff})(R_{eff})$ minimum for a given total junction resistance and interelement thermal conductance.

This concept results in

1. increases in the amount of the thermoelectric semi-conductor material required;

2. cross-sectional area dependents within the elements of the thermoelectric semi-conductor couple; and

3. decrease in design flexibility on the heat source or heat sink flux rates.

In order to avoid these undesirable results, the present invention increases the efficiency in the power output of a thermoelectric generator by introducing support pedestals with different material properties than the basic thermal elements as shown in Fig. 1.

The lengths of the support pedestals 12 and 13 extending beyond the thermoelements 10 and 11 are adjusted, depending upon the material temperature properties of the thermoelements in order to optimize the effective figure of merit ($Z_{eff}$) or the effective power coefficient ($\Psi_{eff}$).

$$\Psi_{eff} = \frac{\left( |\alpha_n| + |\alpha_p| \right)^2}{R_{eff}}$$

The adjustment of the portion of support pedestals 12 and 13 which extend beyond thermoelements 10 and 11 may be not only in length but can require a different cross-sectional area than the associated thermoelements as has been shown in Fig. 1.

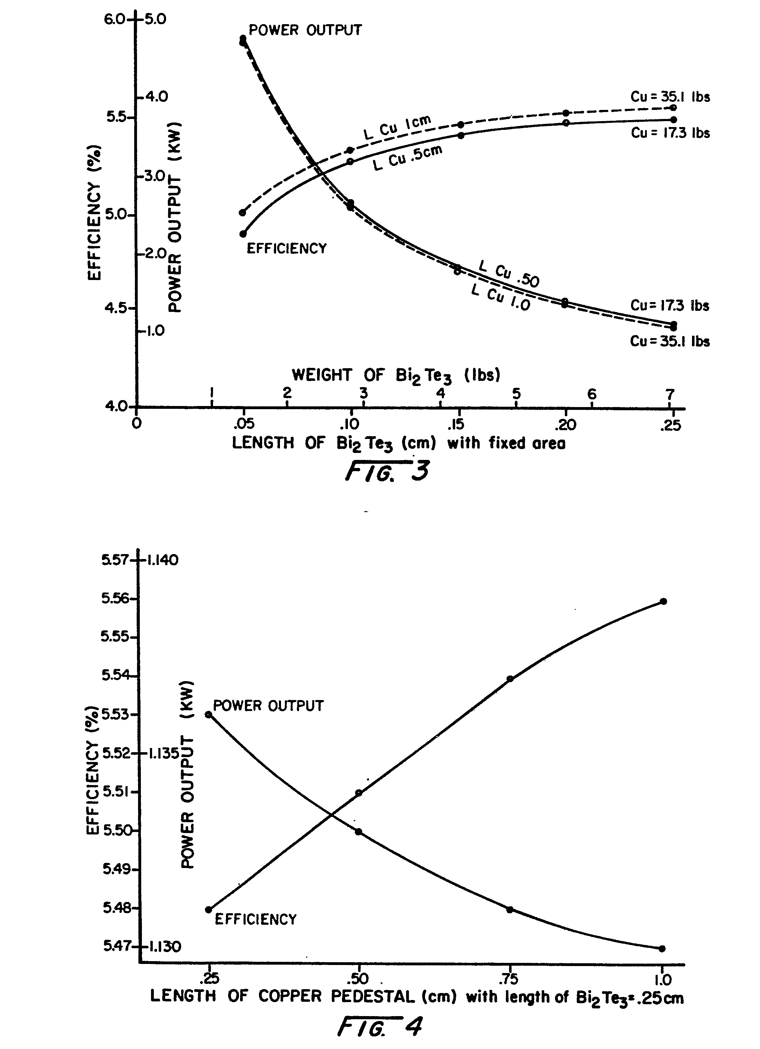

Referring now more particularly to Fig. 3, it will be seen that increasing the length of the thermoelements, while maintaining the pedestal length constant, results in a decrease in power output, coupled with an increase in efficiency. However, for a given length of the thermoelements increasing the length of the support pedestal results in an increase in the efficiency with a extremely small decrease in the power output by comparing the dotted curves with the corresponding solid curves. Of course, increasing the length of the thermoelements beyond a predetermined value will marginally increase the efficiency. The cost of increasing the efficiency by increasing the length of the thermoelectric element will increase faster than the rate of efficiency increase. The rate of decreasing power output is directly related to the increase in electrical resistance.

Referring now more particularly to Fig. 4, it will be seen that increasing the length of the support pedestal increases the efficiency by decreasing the thermal conductance. The rate of decrease in the power output is relatively small as the electrical resistivity of the support pedestal is small as compared to the thermoelement.

The net result is an increase in the effective figure of merit and hence the thermal efficiency.

In constructing the thermoelement of Fig. 1, a thin layer of the thermoelement may be deposited on the support pedestals 12 and 13 as by vacuum deposition so as to form the thermoelements 10 and 11, which may be of different lengths and cross-sectional area. The power output/weight of the thermoelement is greatly improved over nonsupport, thin film configurations. Since the cost of thermoelement material is greater than the support pedestals, the power output/cost would be improved over nonsupport, thin film configurations. Thus it is possible to maximize the use of available energy, increase efficiency, and minimize the mass of thermoelectric material required and maximize the second law efficiency by supporting the required temperature differential between the heat source and the heat sink.

The support pedestals may be constructed of materials such as copper and its alloys or aluminum and its alloys. The support pedestals have relatively high thermal conductivity as compared to the thermoelectric elements, hence the cold side junction temperature of the thermoelement will approach the heat sink temperatures and the change in overall efficiency is extremely small.

This is illustrated in Fig. 5 where a temperature profile is shown. Since the support pedestals are constructed of material of lower electrical resistance than the thermoelectric elements, thus for the same space between the heat source and the heat sink the thermoelectric generator constructed in accordance with this invention will have the potential for more output of electrical power. The net result is to increase the effective figure of merit and hence the overall efficiency for a given difference in heat source and heat sink temperatures.

While this invention has been described in its preferred embodiment, it is appreciated that variations thereon may be made without departing from the scope and spirit of the invention.

## CLAIMS

What is Claimed is:

1. A thermoelectric generator CHARACTERIZED BY two legs of dissimilar thermoelements connected together at one of each of their respective ends, each of said thermoelements being supported throughout the majority of its length by a support pedestal, each of said support pedestals extending beyond the other end of each of said thermoelement legs.

2. The thermoelectric generator of claim 1, CHARAC-TERIZED BY each of said support pedestals being connected to a corresponding support pedestal of a next adjoining· thermoelectric generator.

3. The thermoelectric generator of claim 1 CHARACTERIZED BY said thermoelements being selected from the group consisting of bismuth telluride, lead telluride, and silicon germanium.

4. The thermoelectric generator of claim 1, CHARACTERIZED BY said support pedestals being selected from the group consisting of aluminum and its alloys and copper and its alloys.

5. The thermoelectric generator of claim 2, CHARACTERIZED BY the support and cross-sectional area of said support pedestals being selected by optimizing the effective figure of merit ($Z_{eff}$) of the thermoelectric generator in accordance with the following equation:

$$Z_{eff} = \frac{|\alpha_n| + |\alpha_p|}{R_{eff} \quad K_{eff}}$$

wherein $\alpha_n$ is the sum of the Seebeck coefficients of one series of legs of the thermoelectric generator and $\alpha_p$ is the sum of the Seebeck coefficients of the other legs of the thermoelectric generator and $R_{eff}$ is the effective internal resistance of the system and $K_{eff}$ is the effective thermal conductance of the thermoelectric generator.

6.   The thermoelectric generator of claim 2, CHARACTERIZED BY the length and cross-sectional area of said
support pedestals being selected by optimizing the effective
power coefficient ($\psi_{eff}$) of the thermoelectric generator
in accordance with the following equation:

$$\psi_{eff} = \frac{\left( \left| \alpha_n \right| + \left| \alpha_p \right| \right)^2}{R_{eff}}$$

where $\alpha_n$ is the sum of the Seebeck coefficients of one
series of legs of the thermoelectric generator and $\alpha_p$
is the sum of the Seebeck coefficients of the other legs
of the thermoelectric generator and $R_{eff}$ is the effective
internal resistance of the system.

FIG. 1

FIG. 2

HEAT SOURCE

HEAT SINK

INCREASING
TEMPERATURE

FIG. 5

FIG. 3

FIG. 4